# EUROPEAN PATENT SPECIFICATION

(11) **EP 2 560 469 B1**
(45) Date of publication and mention of the grant of the patent: **16.01.2019**
(21) Application number: 11006760.0
(22) Date of filing: 18.08.2011
(51) Int. Cl.: H05K 5/02

(54) **Venting device comprising a seal protection**
Entlüftungsvorrichtung, die einen Dichtungsschutz umfasst
Dispositif de ventilation comportant une protection par scellage

(43) Date of publication of application: 20.02.2013
(73) Proprietor: W.L.GORE & ASSOCIATES GMBH, 85639 Putzbrunn (DE)
(72) Inventor: Roth, Jörn, 81737 München (DE); Lührs, Léon, 85521 Ottobrunn (DE); Seybel, Mike, 82541 München (DE)
(74) Representative: HGF Limited

(56) References cited:
- EP-A1- 0 831 572
- EP-A1- 1 266 741
- EP-A1- 2 269 874
- WO-A1-2010/076326

## Description

### Background

It is generally know that venting devices can be used to reduce pressure fluctuations as well as to control humidity within electronic housings, while at the same time access of dirt is prevented.

These kind of venting devices normally comprise a water-vapor permeable, water resistant membrane fixed to a support member, said support member is inserted in an opening of an electronic housing such that the opening is closed by the membrane.
In order to avoid air and/or water to enter the housing by circumventing the membrane, a sealing element is necessary between the housing and the venting device. Moreover, the membranes are in general very fragile such that a cap avoiding direct contact of the membrane is reasonable.

Depending on the application of the venting devices certain tests were developed in order to verify "fit for use" criteria with respect to these applications. A very harsh test is the so called IPX9K test (ISO 20653), where high pressure water sprays are arranged at a distance of 10 cm of the venting device and water passing the vent is considered a failure of the device.
In order to pass this test, the venting device must be configured such that the water sprays may not reach the membrane directly, the sealing element resists the water pressure and at the same time sufficient air exchange between the housing and the environment is ensured.

There are already commercially available venting devices, e.g. the automotive vents from W. L. Gore & Associates, Inc. (see e.g. Snap Fit Vents of the AVS series AVS 13, 20 or 46). Other venting devices are described in patent literature. E.g. in EP 2269874 a venting device is described having certain geometry to reduce the direct impact of external pressure on the sealing element. The US 7,626,129 discloses a venting device with a protective structure, wherein this protective structure is designed such that a rod or liquid jet cannot reach the breathable film. The DE 3817227 proposes a venting device comprising a cover and a domed membrane such that water on the membrane will drain off.

EP 831572 discloses a vent filter member comprising an elastomeric member to which a water-repellent film can be fixed. WO 2010/76326 discloses a venting device for insertion into an opening comprising an engagement section being radially deformable. EP 1266741 discloses a gas-permeable plug body being injection molded from a material having rubber-like elasticity.

For the state of the art venting devices this IPX9K test is at least problematic and depending on the geometry of the housing a failure may occur. Therefore, it is the aim of the present invention to provide an improved venting device that will reproducibly pass the IPX9K test independent from geometric circumstances.

### Summary

One aspect of the present invention is a venting device (1) comprising
- a support member (2) having a through hole (3),
- an air permeable membrane layer (4) attached to said support member (2) to cover said through hole (3),
- means (6) to attach said venting device (1) to the opening of a housing (7),
   and
- a sealing element (5) attached to said support member (2),
wherein the air permeable membrane (4) covered through hole (3) allows air exchange between the inside and the outside of said housing (7), when said venting device (1) is attached to said housing (7),
wherein said means (6) to attach said venting device (1) to the opening of a housing (7) is arranged such that upon attaching said venting device (1) to said housing (7) a seal between said housing (7) and said venting device (1) is formed, and
wherein said sealing element (5) is arranged such that upon attaching said venting device (1) to said housing (7) said sealing element (5) is compressed between said support member (2) and said housing (7) to form said seal, characterized in that
said venting device (1) comprises an elastic spacer (8), said elastic spacer (8) is arranged such that upon attaching said venting device (1) to said housing (7) said elastic spacer (8) establishes a contact with said housing to form a seal protection, wherein said seal protection is arranged on an outer perimeter of said through hole (3) compared to said seal.

When the venting device is attached to the housing, the only air exchange between the inside and the outside of the housing should be possible via the air permeable membrane layer covering the through hole within the support member. Therefore, it is necessary to provide a seal between the housing and the venting device. Consequently, this seal preferably surrounds the through hole of the support member without affecting the air exchange via the membrane layer. In other words, the seal is a circumferential seal with respect to said through hole.

To provide the spacer as an elastic spacer has advantages for all reasonable embodiments of the present invention and some preferred embodiments will be described in more detail later in the description. In brief, the deformability enhances the protective properties based on the internal stress within the spacer upon attachment of the venting device to the housing and the respective contact between spacer and housing. In order to produce internal stress within the spacer the extension of the spacer must be larger than the distance between the support member and the housing, when the venting device is attached to the housing. Depending on the elastic properties of the spacer material and the required protection of the seal, the extension of the spacer with respect to the distance between venting device and housing can be adjusted.

Moreover, in some embodiments with e.g. hooks as attaching means the deformability is even necessary to enable the attachment of the venting device to the housing at all, because the hooks need to snatch behind the housing.

Throughout the present invention the term "elastic" means that the material changes its form upon reasonable force and that the material tends to recover its original form after stress relief. On the other hand, the tendency of the elastic spacer to recover its original form must be controlled such that the seal of the venting device is not affected. In other words, the seal of the venting device is the primary seal and the elastic spacer adds only an additional protection to said primary seal.

The elastic spacer provides a protection for the seal surrounding the through hole, whereas throughout the present invention the phrase "seal protection" includes protection against water and/or particles. In other words, the elastic spacer hinders the movement of water and/or particles approaching the seal of the venting device. Consequently, the impact of water and/or particles with the seal is avoided or at least the kinetic energy upon contact with the seal is drastically reduced.

Such that the elastic spacer is able to provide the effect described above, it is of course necessary that the elastic spacer is arranged at an outer perimeter of the venting device with regard to the through hole when compared to the seal. In other words, the elastic spacer preferably surrounds the through hole at a larger distance from the through hole than said seal.

### Brief Description of the Figures

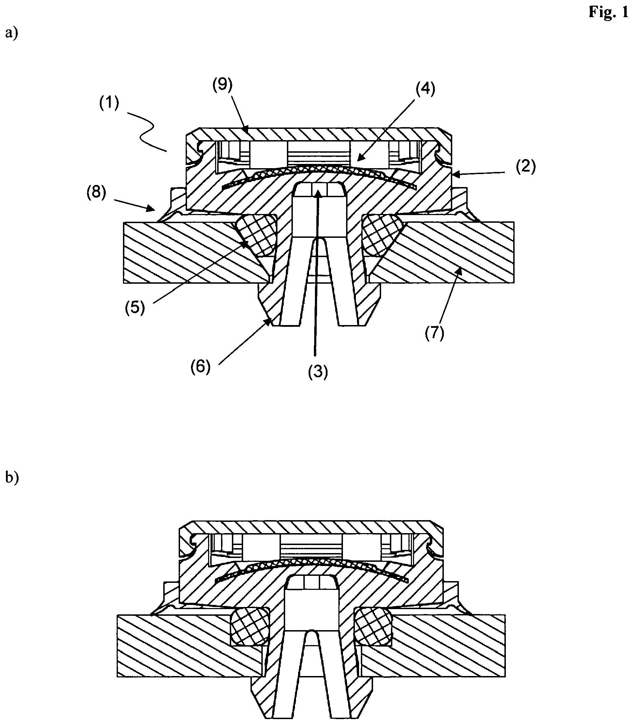

- **Fig. 1:**: Schematic drawings of venting devices according to the present invention attached to housings having different cavities.

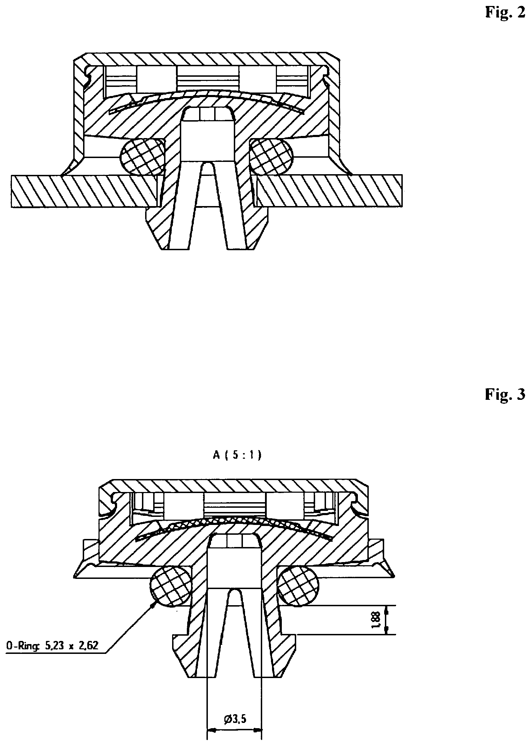

- **Fig. 2:**: Schematic drawing of a venting device according to the present invention attached to a housing without cavity and an elastic spacer attached to cap.
- **Fig. 3:**: Technical drawing of one embodiment of the present invention

### Detailed Description

One aspect of the present invention is a venting device (1) comprising
- a support member (2) having a through hole (3),
- an air permeable layer (4) attached to said support member (2) to cover said through hole (3),
- means (6) to attach said venting device (1) to the opening of a housing (7),
   and
- a sealing element (5) attached to said support member (2),
wherein the air permeable layer (4) covered through hole (3) allows air exchange between the inside and the outside of said housing (7), when said venting device (1) is attached to said housing (7),
wherein said means (6) to attach said venting device (1) to the opening of a housing (7) is arranged such that upon attaching said venting device (1) to said housing (7) a seal between said housing (7) and said venting device (1) is formed, and
wherein said sealing element (5) is arranged such that upon attaching said venting device (1) to said housing (7) said sealing element (5) is compressed between said support member (2) and said housing (7) to form said seal, characterized in that said venting device (1) comprises an elastic spacer (8), said elastic spacer (8) is arranged such that upon attaching said venting device (1) to said housing (7) said elastic spacer (8) establishes a contact with said housing to form a seal protection, wherein said seal protection is arranged on an outer perimeter of said through hole (3) compared to said seal.

As mentioned before, a seal between the venting device and the housing is required to ensure that air is restricted to exchange via the air permeable layer. Therefore, said seal preferably is air impermeable and continuously circumventing the through hole. Depending on the material of the support member it might be possible that such an air impermeable seal can be realized simply by pressurized contact of the venting device and the housing, but it is preferred to apply an additional sealing element to form said seal.

A standard embodiment of such a sealing element is an element generally known as o-ring. But other types and forms of sealing elements are suitable for the present invention, as long as these elements provide a sufficient sealing upon compression during the attachment of the venting device.
Depending on the application of the vent and the properties of the air permeable layer, the seal should be impermeable for water, moisture and/or water vapor, too.

In order to form a seal protection the elastic spacer needs to establish a contact between the venting device and the housing, when the venting device is attached to said housing. In other words, the elastic spacer needs to bridge the gap between the housing and the venting device and there are several ways to arrange the elastic spacer at said venting device.

Depending on the material of the spacer there will be a maximum gap width the spacer may bridge without loosing its protective effect. With the gap becoming larger, the impact area for water on the spacer will become larger, too and consequently, the pressure on the spacer may reach a critical threshold, such that the protective effect is no longer guaranteed.

A preferred venting device according to the present invention is a venting device, wherein said elastic spacer (8) is an integral part of said support member (2).

In this preferred embodiment of the present invention the elastic spacer and the support member are integrally formed. Within the meaning of the present invention the product of a 2-step molding process, whereas the support member forms during the first molding step and the elastic spacer forms during the second molding step is an integrally formed product.

Another preferred venting device according to the present invention is a venting device, wherein said elastic spacer (8) is a separate part attached to said support member (2).

In this preferred embodiment of the present invention the elastic spacer and the support member are assembled from two separate pieces to form a venting device comprising an elastic spacer. For this embodiment, several methods to attach the elastic spacer to the support member are possible. The elastic spacer can be glued, screwed, press-fitted or welded to the support member. Moreover, the support member can be equipped with a recess to receive a respectively formed part of the elastic spacer to realize a snap-fit.

In another preferred venting device according to the present invention, said venting device (1) further comprises a cap (9) attached to said support member (2) to protect said air permeable layer (4) without affecting said air exchange.

The person skilled in the art will know that air permeable layers are often very fragile and therefore, it is preferred to provide a protective means even though it might be difficult to balance the requirements air permeability and protection. A possibility to realize such a protective means in form of a cap can be seen e.g. in a commercial product of W. L. Gore & Associates (Snap Fit Vents of the AVS series AVS 13, 20 or 46). Here, the protective cap rests on pillars such that the area between said pillars defines openings for air exchange. The US 7,626,129 e.g. discloses a venting device with a protective structure, wherein this protective structure is designed such that a rod or liquid jet cannot reach the breathable film.

For embodiments of the present invention comprising a cap, additional possibilities to arrange the elastic spacer are within the scope of the present invention.

A more preferred venting device according to the present invention is a venting device, wherein said elastic spacer (8) is an integral part of said cap (9).

Another more preferred venting device according to the present invention is a venting device, wherein said elastic spacer (8) is a separate part attached to said cap (9).

With respect to the elastic spacer as integral part or as separate part of the cap, the different embodiments described above regarding the elastic spacer arranged at the support member apply here, too.

The elastic spacer forming the seal protection of the present invention can be implemented in several designs as long as particles can not reach the seal and water is ideally deflected or at least slowed down. Besides a continuous material also a mesh, a comb-like structure or a spacer comprising a certain number of holes or cut-outs are suitable designs for the elastic spacer. Designs having a non-continuous structure provide the additional advantage that water that managed to enter the interspace between the elastic spacer and the seal can easily flow out again.

Yet another preferred venting device according to the present invention is a venting device, wherein said seal protection forms an additional seal between said housing (7) and said venting device (1), when said venting device (1) is attached to said housing (7).

In a preferred embodiment the elastic spacer forming the seal protection of the present invention is implemented to establish an additional, second seal between said housing and said venting device. Throughout the present invention a protection becomes a seal by increasing the protective properties, e.g. by replacing a mesh by a continuous material without openings.

In a more preferred venting device according to the present invention, said additional seal between said housing (7) and said venting device (1) is a circumferential seal with respect to said through hole (3).

In embodiments having two seals, the first seal will be the primary seal offering the majority of the sealing properties and the additional, second seal will only have supportive character.

Without being bound by theory, the function of the seal and the spacer will now be described in more details with respect to the IPX9K test mentioned before.

A water jet directed at a venting device without an elastic spacer may find its way into the gap between the support member and the housing and depending on the water pressure, water may pass the seal. This seal failure is based on the tunneling of the seal by water with or without tilting of the venting device.

The elastic spacer of the present invention can help to reduce or even exclude this tunneling. This is possible, because firstly, the elastic spacer acts as a ridge that deflects the water current. Secondly, in case of water pressure strong enough such that water passes the seal and continues in direction to the seal nevertheless, the velocity of the water is at least drastically reduced. Thirdly, the tendency of the elastic spacer to keep its initial form can counteract the tendency of the venting device to tilt and locally reduce its sealing pressure.

Still another preferred venting device according to the present invention is a venting device, wherein said elastic spacer (8) is made of a different material than said support member (2) or said cap (9).

The properties of materials that are suitable for the support member and for the elastic spacer respectively differ to some extend and therefore, it is possible to assemble the venting device with components based on different materials. The venting device as such should have certain stiffness, such that the device does not deform during attachment to a housing or under external stress. On the other hand, the elastic spacer must be softer to deform under reasonable pressure to form the seal protection.

In still another preferred venting device according to the present invention, said elastic spacer (8) is made of the same material as said support member (2) or said cap (9).

In this embodiment of the present invention the same material is used for the support member and the elastic spacer. This is possible, because the properties of the venting device components do not depend only on the used material, but also on the geometric design. E.g. the support member can have a larger stiffness compared to the elastic spacer, because the material forming the elastic spacer is thinner than the material forming the support member.

Yet another preferred venting device according to the present invention is a venting device, wherein said means (6) to attach said venting device (1) to the opening of a housing (7) is at least one hook attached to said support member (2), said at least one hook is arranged to penetrate said opening of said housing (7) in order to attach said venting device (1) to said housing (7).

As mentioned before, in this embodiment according to the present invention it is essential that the spacer is deformable in a manner sufficient to allow proper attachment of the at least one hook to the housing (7). Note that the hook can only snap behind the wall of the housing, if the venting device is pushed further than the resting position of the attached device. Consequently, without deformation of the spacer a gap between the support member and the housing must be present and the effect of the spacer can not develop.

Still another preferred venting device according to the present invention is a venting device, wherein said means (6) to attach said venting device (1) to the opening of a housing (7) is a screw thread attached to said support member (2), said screw thread is arranged to engage with a mating thread at said opening of said housing (7) in order to attach said venting device (1) to said housing (7).

In this embodiment according to the present invention it is not essential that the spacer is deformable, because the geometry can be designed such that no gap remains between the spacer and the housing. Nevertheless, it is still preferred that the spacer (8) is deformable in order to enhance the protective properties.

Depending on the desired application of the venting device certain materials are available that can be used for the different components of the venting device according to the present invention.

In a preferred venting device according to the present invention, said support member (2) is made of glass fiber filled thermoplastic material, preferably PBT GF30 or PA66 GF30.

In the state of the art, such materials are also named glass fiber reinforced plastics. The preferred material PBT GF30 is polybutylenterephtalat with 30 % glass fibers and PA66 GF30 is an aliphatic polyamide having hexamethylendiamine based monomers enforced with 30 % glass fibers.

There a several alternative thermoplastic materials known to the person skilled in the art that are suitable for the venting device of the present invention. Such materials are e.g. Polyphtalamide (PPA), Polyphenyl sulfide (PPS) or polycarbonate (PC), that are available as unfilled material or filled with other components such as glass fibers.

In another preferred venting device according to the present invention, said air permeable layer (4) is an air permeable membrane layer (4).

As mentioned before, the air permeable layer is preferably not only air permeable, but also waterproof.

In a more preferred venting device according to the present invention, said air permeable membrane layer (4) comprises polytetrafluoroethylene (PTFE).

In another more preferred venting device according to the present invention, said air permeable membrane layer (4) is a PTFE layer or a PTFE laminate comprising a non-woven support layer.

Using PTFE as a membrane material offers at least two different possibilities, namely to use a pure PTFE layer or a PTFE layer combined with one or more supporting material, e.g. a fabric, a non-woven, a grid or a mesh. The combination of a PTFE layer with supporting material is called PTFE laminate throughout the present application.

In yet another more preferred venting device according to the present invention, said air permeable membrane layer (4) is an ePTFE (expanded PTFE) layer or an ePTFE laminate comprising a non-woven support layer.

In yet another preferred venting device according to the present invention, said elastic spacer (8) is made of a flexible, un-filled thermoplastic material, preferably PA66.

In still another preferred venting device according to the present invention, said elastic spacer (8) is made of rubber or thermoplastic elastomers (TPE) material having high stiffness, preferably silicon rubber or ethylene-propylene-diene monomer rubber (EPDM).

Other examples of suitable TPEs are thermoplastic polyurethane elastomers (TPE-U), thermoplastic polystyrole elastomers (TPE-S) or thermoplastic polyamide elastomers (TPE-A).

In another preferred venting device according to the present invention, said cap (9) is made of glass fiber filled thermoplastic material, preferably PBT GF30 or PA66 GF30.

### Example

A venting device with seal protection according to the present invention is produced as follows.

The components of the venting device are the support member, an ePTFE membrane, an O-ring, a cap and the elastic spacer forming the seal protection. These components are produced separately and assembled afterwards.

### Production process of the support member:

The support member is a plastic component that is produced in a so called insert molding process. For producing this component a standardized horizontal injection molding machine equipped with a multi-zone plasticizing unit is used. The molding tool is constructed as a multi-cavity insert molding tool.

At beginning of the production process the thermoplastic material PBT GF30 (polybutylenterephtalat with 30 % glass fibers) is plasticized. It will be injected into the cavities under controlled process parameters (temperatures, pressures, time). The Gore™ membrane material (ePTFE membrane with polyester fleece as support material, analogous to the Snap Fit Vents of the AVS series AVS 13, 20 or 46, W. L. Gore & Associates, Inc.) has been placed within the molding tool before the injection process and therefore, the membrane will be embedded into the support member. This creates a stable and water tight connection between the membrane and the support member of the vent. After a sufficient cool down time the component will be removed from the tool and transferred to an assembly line. In this assembly line other components like the O-ring (for sealing the vent with the customers housing) and the snap-fit cap as membrane protection (injection molded with a multi-cavity insert molding tool using PBT GF30) are assembled.

### Production process of the elastic spacer:

The elastic spacer is produced with a standardized injection molding machine using a multi-cavity Molding tool, too.

The thermoplastic material PA66 (aliphatic polyamide having hexamethylendiamine based monomers) is plasticized and injected into the respective molding tool. After a cool down time the components are removed from the tool.

### Assembling process:

The assembly of the elastic spacer to the support member can be done either manually or automated. In this process, the elastic spacer will assemble with the support member via a snap-fit.

Based on tolerances of the production process, the elastic spacer of this embodiment bridges a gap of around 0.6 to 1 mm.

## Claims

1. Venting device (1) comprising
- a support member (2) having a through hole (3),
- an air permeable layer (4) attached to said support member (2) to cover said through hole (3),
- means (6) to attach said venting device (1) to the opening of a housing (7),
and
- a sealing element (5) attached to said support member (2),
wherein the air permeable layer (4) covered through hole (3) allows air exchange between the inside and the outside of said housing (7), when said venting device (1) is attached to said housing (7),
wherein said means (6) to attach said venting device (1) to the opening of a housing (7) is arranged such that upon attaching said venting device (1) to said housing (7) a seal between said housing (7) and said venting device (1) is formed, and
wherein said sealing element (5) is arranged such that upon attaching said venting device (1) to said housing (7) said sealing element (5) is compressed between said support member (2) and said housing (7) to form said seal,
**characterized in that**
said venting device (1) comprises an elastic spacer (8), said elastic spacer (8) is arranged such that upon attaching said venting device (1) to said housing (7) said elastic spacer (8) establishes a contact with said housing to form a seal protection, wherein said seal protection is arranged on an outer perimeter of said through hole (3) compared to said seal.

2. The venting device according to claim 1, wherein
said elastic spacer (8) is an integral part of said support member (2).

3. The venting device according to claim 1, wherein
said elastic spacer (8) is a separate part attached to said support member (2).

4. The venting device according to claim 1, wherein
said venting device (1) further comprises a cap (9) attached to said support member (2) to protect said air permeable layer (4) without affecting said air exchange.

5. The venting device according to claim 4, wherein
said elastic spacer (8) is an integral part of said cap (9).

6. The venting device according to claim 4, wherein
said elastic spacer (8) is a separate part attached to said cap (9).

7. The venting device according to claims 4-6, wherein
said elastic spacer (8) is made of a different material than said support member (2) or said cap (9).

8. The venting device according to claims 4-6, wherein
said elastic spacer (8) is made of the same material as said support member (2) or said cap (9).

9. The venting device according to claims 1-8, wherein
said means (6) to attach said venting device (1) to the opening of a housing (7) is at least one hook attached to said support member (2), said at least one hook is arranged to penetrate said opening of said housing (7) in order to attach said venting device (1) to said housing (7).

10. The venting device according to claims 1-8, wherein
said means (6) to attach said venting device (1) to the opening of a housing (7) is a screw thread attached to said support member (2), said screw thread is arranged to engage with a mating thread at said opening of said housing (7) in order to attach said venting device (1) to said housing (7).

11. The venting device according to claims 1-10, wherein
said support member (2) is made of glass fiber filled thermoplastic material, preferably PBT GF30 or PA66 GF30.

12. The venting device according to claims 1-11, wherein
said air permeable layer (4) is an air permeable membrane layer (4).

13. The venting device according to claim 12, wherein
said air permeable membrane layer (4) is a PTFE layer or a PTFE laminate comprising a non-woven support layer.

14. The venting device according to claims 1-13, wherein
said elastic spacer (8) is made of an flexible, un-filled thermoplastic material, preferably PA66.

## Patentansprüche

1. Entlüftungsvorrichtung (1), umfassend ein Stützglied (2) mit einem Durchgangsloch (3), einer am Stützglied (2) zum Abdecken des Durchgangslochs (3) angebrachten luftdurchlässigen Schicht (4),
- Mittel (6) zum Anbringen der Entlüftungsvorrichtung (1) an die Öffnung eines Gehäuses (7), und ein Dichtungselement (5), das am Stützglied (2) angebracht ist, wobei das von der luftdurchlässigen Schicht (4) abgedeckte Durchgangsloch (3) den Luftaustausch zwischen dem Inneren und Äußeren des Gehäuses (7) zulässt, wenn die Entlüftungsvorrichtung (1) am Gehäuse (7) angebracht ist, wobei das Mittel (6) zum Anbringen der Entlüftungsvorrichtung (1) an die Öffnung eines Gehäuses (7) so angeordnet ist, dass beim Anbringen der Entlüftungsvorrichtung (1) an das Gehäuse (7) eine Dichtung zwischen dem Gehäuse (7) und der Entlüftungsvorrichtung (1) geformt wird, und wobei das Dichtungselement (5) so angeordnet ist, dass das Dichtungselement (5) beim Anbringen der Entlüftungsvorrichtung (1) an das Gehäuse (7) zwischen dem Stützglied (2) und dem Gehäuse (7) komprimiert wird, um die Dichtung zu formen, **dadurch gekennzeichnet, dass** die Entlüftungsvorrichtung (1) einen elastischen Abstandhalter (8) umfasst, wobei der elastische Abstandhalter (8) so angeordnet ist, dass der elastische Abstandhalter (8) beim Anbringen der Entlüftungsvorrichtung (1) an das Gehäuse (7) einen Kontakt zum Gehäuse herstellt, um einen Dichtungsschutz bereitzustellen, wobei der Dichtungsschutz an einem Außenumfang des Durchgangslochs (3) im Vergleich zur Dichtung angeordnet ist.

2. Entlüftungsvorrichtung nach Anspruch 1, wobei der elastische Abstandhalter (8) ein integraler Teil des Stützglieds (2) ist.

3. Entlüftungsvorrichtung nach Anspruch 1, wobei der elastische Abstandhalter (8) ein separater Teil ist, der an das Stützglied (2) angebracht ist.

4. Entlüftungsvorrichtung nach Anspruch 1, wobei die Entlüftungsvorrichtung (1) ferner eine Kappe (9) umfasst, die am Stützglied (2) angebracht ist, um die luftdurchlässige Schicht (4) zu schützen, ohne den Luftaustausch zu beeinflussen.

5. Entlüftungsvorrichtung nach Anspruch 4, wobei der elastische Abstandhalter (8) ein integraler Teil der Kappe (9) ist.

6. Entlüftungsvorrichtung nach Anspruch 4, wobei der elastische Abstandhalter (8) ein separater Teil ist, der an der Kappe (9) angebracht ist.

7. Entlüftungsvorrichtung nach Ansprüchen 4-6, wobei der elastische Abstandhalter (8) aus anderem Material als das Stützglied (2) oder die Kappe (9) hergestellt ist.

8. Entlüftungsvorrichtung nach Ansprüchen 4-6, wobei der elastische Abstandhalter (8) aus demselben Material wie das Stützglied (2) oder die Kappe (9) hergestellt ist.

9. Entlüftungsvorrichtung nach Ansprüchen 1-8, wobei das Mittel (6) zum Anbringen der Entlüftungsvorrichtung (1) an der Öffnung eines Gehäuses (7) mindestens ein am Stützglied (2) angebrachter Haken ist, wobei der mindestens eine Haken angeordnet ist, um durch die Öffnung des Gehäuses (7) zu dringen, um die Entlüftungsvorrichtung (1) am Gehäuse (7) anzubringen.

10. Entlüftungsvorrichtung nach Ansprüchen 1-8, wobei das Mittel (6) zum Anbringen der Entlüftungsvorrichtung (1) an der Öffnung eines Gehäuses (7) ein am Stützglied (2) angebrachtes Schraubgewinde ist, wobei das Schraubgewinde angeordnet ist, um ein entsprechendes Gewinde an der Öffnung des Gehäuses (7) in Eingriff zu nehmen, um die Entlüftungsvorrichtung (1) am Gehäuse (7) anzubringen.

11. Entlüftungsvorrichtung nach Ansprüchen 1-10, wobei das Stützglied (2) aus glasfasergefülltem thermoplastischem Material, vorzugsweise PBT GF30 oder PA66 GF30, hergestellt ist.

12. Entlüftungsvorrichtung nach Ansprüchen 1-11, wobei die luftdurchlässige Schicht (4) eine luftdurchlässige Membranschicht (4) ist.

13. Entlüftungsvorrichtung nach Anspruch 12, wobei die luftdurchlässige Membranschicht (4) eine PTFE-Schicht oder ein PTFE-Laminat, umfassend eine Vliesstützschicht ist.

14. Entlüftungsvorrichtung nach Ansprüchen 1-13, wobei der elastische Abstandhalter (8) aus flexiblem, nicht gefülltem thermoplastischem Material, vorzugsweise PA66, hergestellt ist.

## Revendications

1. Dispositif de ventilation (1) comprenant
- un élément de support (2) possédant un trou traversant (3),
- une couche perméable à l'air (4) fixée audit élément de support (2) pour couvrir ledit trou traversant (3),
- un moyen (6) pour fixer ledit dispositif de ventilation (1) à l'ouverture d'un boîtier (7) et
- un élément d'étanchéité (5) fixé audit élément de support (2), ledit trou traversant (3) couvert par la couche perméable à l'air (4) permettant un échange d'air entre l'intérieur et l'extérieur dudit boîtier (7), lorsque ledit dispositif de ventilation (1) est fixé audit boîtier (7),
ledit moyen (6) pour fixer ledit dispositif de ventilation (1) à l'ouverture d'un boîtier (7) étant agencé de sorte que lors de la fixation dudit dispositif de ventilation (1) audit boîtier (7) un joint d'étanchéité entre ledit boîtier (7) et ledit dispositif de ventilation (1) soit formé, et ledit élément d'étanchéité (5) étant agencé de sorte que lors de la fixation dudit dispositif de ventilation (1) audit boîtier (7) ledit élément d'étanchéité (5) soit comprimé entre ledit élément de support (2) et ledit boîtier (7) pour former ledit joint d'étanchéité, **caractérisé en ce que** ledit dispositif de ventilation (1) comprend une entretoise élastique (8), ladite entretoise élastique (8) étant agencée de sorte que lors de la fixation dudit dispositif de ventilation (1) audit boîtier (7) ladite entretoise élastique (8) établisse un contact avec ledit boîtier pour former une protection d'étanchéité, ladite protection d'étanchéité étant agencée sur un périmètre externe du dit trou traversant (3) par rapport audit joint d'étanchéité.

2. Dispositif de ventilation selon la revendication 1, ladite entretoise élastique (8) faisant partie intégrante dudit élément de support (2).

3. Dispositif de ventilation selon la revendication 1, ladite entretoise élastique (8) étant une partie distincte fixée audit élément de support (2).

4. Dispositif de ventilation selon la revendication 1, ledit dispositif de ventilation (1) comprenant en outre un couvercle (9) fixé audit élément de support (2) pour protéger ladite couche perméable à l'air (4) sans affecter ledit échange d'air.

5. Dispositif de ventilation selon la revendication 4, ladite entretoise élastique (8) faisant partie intégrante dudit couvercle (9).

6. Dispositif de ventilation selon la revendication 4, ladite entretoise élastique (8) étant une partie distincte fixée audit couvercle (9).

7. Dispositif de ventilation selon les revendications 4 à 6, ladite entretoise élastique (8) étant constituée d'un matériau différent dudit élément de support (2) ou dudit couvercle (9).

8. Dispositif de ventilation selon les revendications 4 à 6, ladite entretoise élastique (8) étant constituée du même matériau que ledit élément de support (2) ou ledit couvercle (9).

9. Dispositif de ventilation selon les revendications 1 à 8, ledit moyen (6) pour fixer ledit dispositif de ventilation (1) à l'ouverture d'un boîtier (7) étant au moins un crochet fixé audit élément de support (2), ledit au moins un crochet étant agencé pour pénétrer dans ladite ouverture dudit boîtier (7) afin de fixer ledit dispositif de ventilation (1) audit boîtier (7).

10. Dispositif de ventilation selon les revendications 1 à 8, ledit moyen (6) pour fixer ledit dispositif de ventilation (1) à l'ouverture d'un boîtier (7) étant un filetage fixé audit élément de support (2), ledit filetage étant agencé pour se mettre en prise avec un taraudage correspondant au niveau de ladite ouverture dudit boîtier (7) afin de fixer ledit dispositif de ventilation (1) audit boîtier (7).

11. Dispositif de ventilation selon les revendications 1 à 10, ledit élément de support (2) étant constitué de matériau thermoplastique rempli de fibres de verre, de préférence du PBT GF30 ou du PA66 GF30.

12. Dispositif de ventilation selon les revendications 1 à 11, ladite couche perméable à l'air (4) étant une couche de membrane perméable à l'air (4).

13. Dispositif de ventilation selon la revendication 12, ladite couche de membrane perméable à l'air (4) étant une couche PTFE ou un stratifié PTFE comprenant une couche de support non tissée.

14. Dispositif de ventilation selon les revendications 1 à 13, ladite entretoise élastique (8) étant constituée d'un matériau thermoplastique souple, non rempli, de préférence du PA66.
